# EUROPEAN PATENT APPLICATION

(11) **EP 4 685 839 A1**
(43) Date of publication of application: **28.01.2026**
(21) Application number: 25190634.3
(22) Date of filing: 21.07.2025
(51) Int. Cl.: H01J 37/32, B82Y 40/00, C01B 32/162

(54) **METHOD OF VALVE CONTROL FOR CVD SYSTEM**

(30) Priority: 23.07.2024 FI 20245917
(71) Applicant: Canatu Finland Oy, 01720 Vantaa (FI)
(72) Inventor: Koskinen, Tomi, 01720 Vantaa (FI); Juntunen, Taneli, 01720 Vantaa (FI); Liimatainen, Marko, 01720 Vantaa (FI)
(74) Representative: Papula Oy

(57) **Abstract**

Disclosed is a method and a system for chemical vapor deposition. A collection valve between a reactor and a collection chamber and a purge valve between the collection valve and the collection chamber is open while a bypass valve for the collection chamber is open for purging debris from between the collection valve and the bypass valve through the bypass valve. Thereafter, the purge valve is closed and the collection valve open for directing the deposition product from the reactor to the collection chamber for treatment.

## Description

### FIELD

The present invention relates to valve control for a chemical vapor deposition (CVD) system.

### BACKGROUND

A specific type of a chemical vapor deposition (CVD) system has a reactor for creating a deposition product separate from a collection chamber for treatment of the deposition product for providing a CVD product. In such a system, when the deposition product is transferred from the reactor to the collection chamber, debris may enter into the collection chamber contaminating the deposition product.

### SUMMARY

It is an objective to provide a method and a system for mitigating the problem of contamination.

For this purpose, a valve control sequence for the CVD system and a system for performing the valve control sequency are presented.

According to a first aspect, a method of valve control for a chemical vapor deposition (CVD) system is disclosed. The CVD system has a reactor for creating a deposition product, a collection chamber for treatment, such as chemical vapor deposition, of the deposition product, in particular for providing a CVD product, and a gas distribution system (GDS) for transferring the deposition product from the reactor to the collection chamber. The method comprises having a collection valve of the GDS between the reactor and the collection chamber and a purge valve of the GDS between a bypass valve and the collection chamber open while the bypass valve for the collection chamber is open for purging debris from between the purge valve and the bypass valve through the bypass valve. The purge valve being open can provide a flow of purging gas into the gas distribution system. The collection valve being open allows the purging gas to drive debris away from the collection valve while the positioning of the purge valve with respect to the collection chamber and the collection valve allows the debris to be driven in a direction away from the collection chamber. The bypass valve being open allows the debris to be driven through the bypass valve in a direction away from the collection chamber.

Thereafter, the method comprises having the purge valve closed and the collection valve open for directing the deposition product from the reactor to the collection chamber for treatment. The collection valve being open allows flow from the reactor to be directed through the collection valve to the collection chamber. The purge valve being closed mitigates counterflow so that the deposition product may pass the purge valve to the collection chamber. As a result, the treatment may be conducted without contamination from the debris purged through the bypass valve utilizing the purge valve. Contamination on the treatment and the CVD product may thus be reduced. The treatment performed in the collection chamber may include deposition, such as chemical vapor deposition, or product collection, isolation, processing in a vacuum system, product removal and any combination thereof.

In an embodiment, the method comprises having the purge valve closed together with the bypass valve for directing the deposition product from the reactor to the collection chamber for treatment. The bypass valve being closed not only blocks the debris driven through the bypass valve from returning to contaminate the treatment but also allows larger part of the deposition product from the reactor to be directed to the collection chamber.

In an embodiment, the collection valve is open together with an exhaust valve for the collection chamber for directing the deposition product from the reactor to the collection chamber for the treatment. The exhaust valve being open allows the deposition product to be efficiently transferred into the collection chamber.

In an embodiment, the bypass valve and the exhaust valve are control valves. This allows the bypass valve and the exhaust valve assume one or more positions that are between being fully open and fully closed, for example continuously. The bypass valve is moved from an open position to a closed position as the exhaust valve is moved from a closed position to an open position for directing the deposition product from the reactor to the collection chamber for the treatment. This allows the bypass valve and the exhaust valve to be partially open simultaneously which can lead to a gradual, or slow, reverse of the flow direction from a bypass direction to the collection chamber direction, as opposed to an abrupt change of direction. This can provide a uniform quality of the resulting CVD product. Another effect of this embodiment is that reactor pressure can remain constant as a result, and this may reduce detachment of particles from the walls of the reactor and collection arm.

In an embodiment, the method comprises having the collection valve and the exhaust valve closed while having an inlet valve open for adjusting pressure difference across the collection valve before opening the collection valve for purging the debris from between the collection valve and the bypass valve through the bypass valve. This allows improved control on purging the debris. The pressure on the side of the purge valve with respect to the collection valve may be adjusted different from the pressure on the opposite side of the collection valve, i.e. on the side of the bypass valve. In particular, it may be adjusted equal to or larger than said pressure making it easier to purge the debris in a direction away from the collection valve.

In an embodiment the inlet valve is the purge valve. This allows efficient system construction as the purge valve may be utilized for multiple purposes.

In an embodiment, a flow from the purge valve is maintained smaller during the purging in comparison to a flow from the reactor. This allows mitigating or preventing backflow into the reactor even in the event of the bypass valve being partially or fully blocked.

According to a second aspect, a chemical vapor deposition (CVD) system is disclosed. The system comprises a reactor for creating a deposition product, a collection chamber for treatment of the deposition product for providing a CVD product, a bypass valve for the collection chamber and a gas distribution system (GDS) for transferring the deposition product from the reactor to the collection chamber. The GDS may comprise, at least, a collection valve between the reactor and the collection chamber and a purge valve between the collection valve and the collection chamber. The system may further comprise one or more controllers for controlling the bypass valve, the collection valve and the purge valve.

The one or more controllers may be configured to have the collection valve and the purge valve open while the bypass valve is open for purging debris from between the collection valve and the bypass valve through the bypass valve, and thereafter, have the purge valve closed and the collection valve open for directing the deposition product from the reactor to the collection chamber for treatment.

What is stated above regarding the first aspect may be applied also to the second aspect.

In an embodiment, the one or more controllers are configured to have the purge valve closed together with the bypass valve for directing the deposition product from the reactor to the collection chamber for the treatment.

In an embodiment, the system comprises an exhaust valve of the collection chamber, wherein the one or more controllers are configured to have the collection valve open together with the exhaust valve for directing the deposition product from the reactor to the collection chamber for the treatment.

In an embodiment, the bypass valve and the exhaust valve are control valves, and the one or more controllers are configured to move the bypass valve from an open position to a closed position as the exhaust valve is moved from a closed position to an open position for directing the deposition product from the reactor to the collection chamber for the treatment. This allows the bypass valve and the exhaust valve to be partially open simultaneously. This can lead to a gradual reverse of the flow direction from a bypass direction to the collection chamber direction, as opposed to an abrupt change of direction. A uniform quality of the resulting CVD product can be achieved. In addition, reactor pressure can remain constant, and this may reduce detachment of particles from the walls of the reactor and collection arm.

In an embodiment, the one or more controllers are configured to have the collection valve and the exhaust valve closed while having an inlet valve open for adjusting pressure difference across the collection valve before opening the collection valve for purging the debris from between the collection valve and the bypass valve through the bypass valve.

In an embodiment, the inlet valve is the purge valve.

In an embodiment, the one or more controllers are configured to maintain a flow from the purge valve smaller during the purging in comparison to a flow from the reactor. This can work as a security measure to prevent the reactor from being contaminated by the debris even in the case the exhaust arm is clogged during the purging.

What is stated above regarding the embodiments of the first aspect may be applied also to the embodiments of the second aspect.
For the CVD system as disclosed, volumes of recirculating gas flow may be developed in the gas distribution system (GDS). This recirculating gas flow can result in accumulation of debris, which may enter into the collection chamber to contaminate the deposition product.

The disclosed solutions provide a valve control sequence, which allows purging parts of the gas distribution system that would not be purged under normal operation of the system. The presented valve control sequence can result in a reduced amount of debris in the collection chamber and therefore also on the product fabricated in the reactor, improving yield and quality.

It should be noted that all instances of a valve being "open" herein may refer to said valve being partially open or said valve being fully open. Similarly, all instances of a valve being "closed" herein may refer to said valve being partially closed or said valve being fully closed.

It is to be understood that the aspects and embodiments described above may be used in any combination with each other. Several of the aspects and embodiments may be combined together to form a further embodiment of the invention.

### BRIEF DESCRIPTION OF THE DRAWINGS

The accompanying drawings, which are included to provide a further understanding and constitute a part of this specification, illustrate examples and together with the description help to explain the principles of the disclosure. In the drawings:
**Figs. 1-7** illustrate valve control according to one or more examples, and
Fig. 8 illustrates a method according to an example.

Like references are used to designate equivalent or at least functionally equivalent parts in the accompanying drawings.

### DETAILED DESCRIPTION

The detailed description provided below in connection with the appended drawings is intended as a description of examples and is not intended to represent the only forms in which the example may be constructed or utilized. However, the same or equivalent functions and structures may be accomplished by different examples.

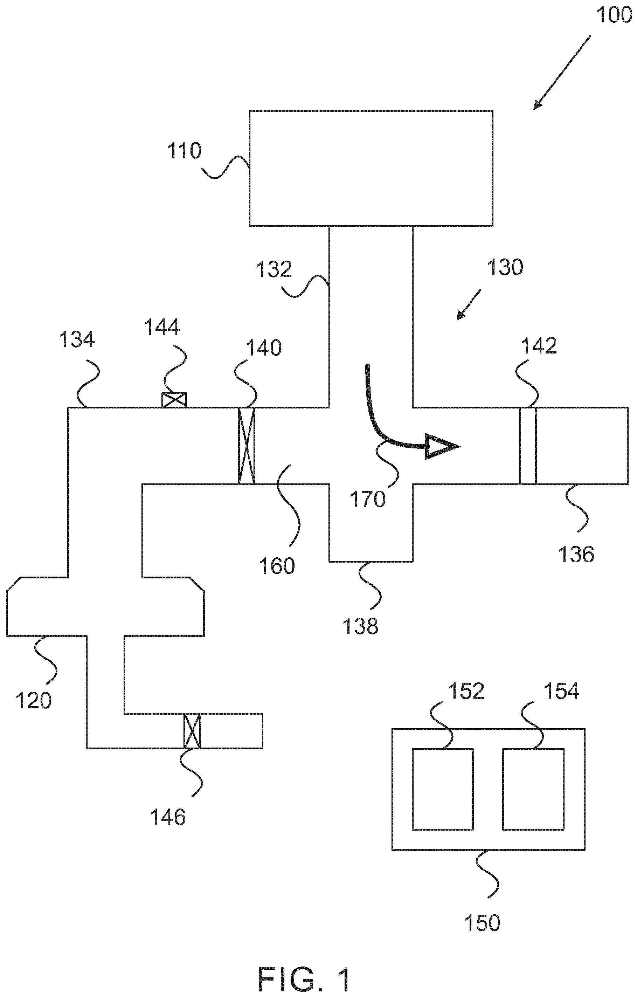

Figs. 1-7 illustrate valve control according to one or more examples. Valve control as disclosed herein may be performed utilizing a chemical vapor deposition (CVD) system 100 (herein also "the system"). In particular, the CVD system may be a floating-catalyst chemical vapor deposition (FCCVD) system, or an aerosol CVD system.

The system comprises a reactor 110, such as a FCCVD reactor, which may be configured for creating a deposition product. The reactor may be configured for creating the deposition product with the help of a catalyst, such as an aerosol. The system also comprises a collection chamber 120, which may be configured for treatment of the deposition product for providing a CVD product. The treatment performed in the collection chamber 120 may include deposition, such as chemical vapor deposition, or product collection, isolation, processing in a vacuum system, product removal and any combination thereof. The deposition product may comprise or consist of nanostructures, such as high-aspect ratio molecular (HARM) structures. The HARM structures may have length 50-10000 times or larger than their maximum diameter. In this sense, they may be considered substantially one-dimensional structures. The HARM-structures may comprise or consist of carbon nanostructures, for example carbon nanotubes (CNTs), such as single-walled CNTs and/or multi-walled CNTs, carbon nano-buds (molecule having a fullerene molecule covalently bonded to the side of a carbon nano tube), carbon nanoribbons, or any combination thereof. Alternatively or additionally, the HARM-structures may comprise other types of HARM-structures such as cellulose fibers, nanorods or nanowires, e.g. silver nanowires or III-V semiconductor nanowires. The HARM-structures may comprise or consist of uncoated structures and/or coated structures, such as coated CNTs. The deposition product may be deposited in a substantially planar network of the HARM-structures. The HARM-structures may be oriented substantially randomly in the network. The HARM-structures may be electrically conductive HARM-structures.

The system comprises a gas distribution system (GDS) 130, which may be configured for transferring the deposition product from the reactor to the collection chamber. The GDS may comprise multiple arms. Gas supply through any or all of the arms may be controlled by a valve situated at the corresponding arm. For example, the GDS may comprise a path from the reactor to the collection chamber and this may be formed by one, two or more arms. A reactor arm 132 may be provided for transferring the deposition product from the reactor and this arm may be connected, directly or indirectly to a collection arm 134 for transferring the deposition product to the collection chamber. The reactor arm and the collection arm may also be joined as a single monolithic arm. In such a case, the reactor arm may correspond to a reactor-side region of the monolithic arm and the collection arm to a chamber-side region of the monolithic arm.

The system may also comprise a bypass arm 136 for directing gas flow in a direction away from the reactor and the collection chamber. The bypass arm may be configured for directing gas in a direction away from the reactor and from the collection chamber to a bypass exhaust. A filter may be situated at the bypass exhaust for collecting the deposition product, which may afterwards be discarded. The bypass arm may be considered a part of the GDS.

The collection arm, the reactor arm and the bypass arm may extend away from each other, for example from a common origin. They may be arranged in a T-shaped pattern, as illustrated in Figs. 1-7. The GDS may also comprise a monitoring and/or cleaning window 138, for example at an extension arm of the GDS. The extension arm may be separate from the reactor arm, the bypass arm and the collection arm. It may be joined to one or more of said arms, extend away from the corresponding arm(s). For example, it may extend from the origin, as illustrated.
The system may comprise a collection valve 140, which may be considered as part of the GDS. The collection valve may be located between the reactor and the collection chamber, in particular at the collection arm. The collection valve may be configured for, in an open position, partially or fully permitting gas flow for facilitating transmission of the deposition product from the reactor to the collection chamber. The system may be configured so that the exhaust valve, as defined below, needs also to be open, partially or fully, for the gas flow to be permitted to transmit the deposition product from the reactor to the collection chamber. The collection valve may be configured for, in a closed position, partially or fully blocking gas flow for preventing transmission of the deposition product from the reactor to the collection chamber. The collection valve may be a control valve, such that it can assume one or more positions between a maximally open position and a maximally closed position, for example continuously. This allows adjusting the degree of openness for the collection valve.

The system may also comprise a bypass valve 142, which may be considered as part of the GDS. It allows bypass of the collection chamber, or the collection arm altogether. The bypass valve may be located away from the reactor and the collection chamber, in particular at the bypass arm. The bypass valve may be configured for allowing gas flow from the reactor to bypass the collection chamber. The bypass valve may be configured for, in an open position, partially or fully permitting gas flow for facilitating transmission of the deposition product from the reactor to the bypass exhaust. The bypass valve may be configured for, in a closed position, partially or fully blocking gas flow for preventing transmission of the deposition product from the reactor to the bypass exhaust. The bypass valve may be a control valve, such that it can assume one or more positions between a maximally open position and a maximally closed position, for example continuously. This allows adjusting the degree of openness for the bypass valve.

The system may comprise a purge valve 144, which may be considered as part of the GDS. The purge valve may be located between the collection valve and the collection chamber, in particular at the collection arm. It may be configured for facilitating release of purging gas into the GDS for purging the GDS. While nitrogen may be provided as a particularly effective example for the purging gas, it should be understood that any gas known to a person skilled in the art and suitable for purging debris from the GDS may be utilized. The purge valve may be a directional valve or non-directional valve. In particular, the purge valve may be configured for facilitating the release of the gas through the collection valve, when the collection valve is open, to purge debris from vicinity of the collection valve towards the bypass valve. The purge valve may be configured for, in an open position, partially or fully permitting gas flow for facilitating transmission of debris between the reactor and the collection valve towards the bypass valve, or to the bypass exhaust when the bypass valve is open. In a closed position, the purge valve may block the aforementioned gas from entering the GDS, or the collection arm in particular. The purge valve may be a control valve, such that it can assume one or more positions between a maximally open position and a maximally closed position, for example continuously. This allows adjusting the degree of openness for the purge valve.

The system may comprise an exhaust valve 146 for the collection chamber. The exhaust valve may be considered as part of the GDS. The exhaust valve may be located at the collection chamber or downstream from the collection chamber, e.g. at the collection arm. It may be configured for facilitating removal of gas from the collection chamber, in particular in a direction away (along a gas transmission path) from the collection valve. The exhaust valve may be configured for, in an open position, partially or fully permitting gas flow for facilitating removal of gas from the collection chamber. The exhaust valve may be configured for, in a closed position, partially or fully blocking gas flow for preventing removal of gas from the collection chamber through the exhaust valve. The exhaust valve may be a control valve, such that it can assume one or more positions between a maximally open position and a maximally closed position, for example continuously. This allows adjusting the degree of openness for the exhaust valve. Passage of gas to and from the collection chamber may be controlled, at least, by the exhaust valve and/or the collection valve. The purge valve (and/or the inlet valve as defined below) may also be arranged with an open connection to the collection chamber for gas transfer.

The system may comprise one or more controllers 150 for controlling any or all of the valves. This applies to any or all of the bypass valve, the collection valve, the purge valve and the exhaust valve. The one or more controllers may comprise one or more processors 152 for this purpose. For the same purpose, the one or more controllers may also comprise one or more memories 154. The one or more memories may comprise instructions which, when the instructions are executed by the one or more processors, cause any of the actions related to valve control as disclosed herein to be performed. The one or more controllers may be configured for controlling any or all of the valves through a wired connection and/or a wireless connection.

Any or all of the valves mentioned herein may be electrically, pneumatically or hydraulically controllable valves. As such, any or all of the valves may be provided as automated valves or actuated valves. Any or all of the valves may incorporate an actuator to automate the opening, closing, or modulation of the valve based on external signals or commands, in particular from the one or more controllers. The actuator may be powered by any combination of electricity, compressed air (pneumatics) and compressed fluid (hydraulics). In particular, as mentioned, any or all of the valves may be control valves, such as throttling valves. This allows them to be controlled into one or more intermediate positions between fully open and fully closed. Any or all of the valves may be configured so that such control can be made stepwise and/or continuously. Additionally, the valve or valves can be controlled individually, in selected groups, or all together. Any or all of the valves may be configured to allow for incremental adjustments to the valve position, enabling fine control over gas flow at said valve(s). Control valves with throttling valves in particular allow maintaining a specific flow rate.

Debris 160 may accumulate between the collection valve and the bypass valve. In particular, debris may accumulate at the collection valve, on the side of the reactor. Valve control as disclosed herein allows preventing such debris from entering the collection chamber.

The valve control may involve any or all of the actions as described herein. It may be performed as a valve control sequence, which may be programmed for the one or more controllers, for example as included in the instructions. For the purpose of illustrating valve control, Figs. 1-7 have closed valves indicated as crossed (valves 140, 144, 146 in Fig. 1) and open valves indicated as uncrossed (valve 142 in Fig. 1). In particular, the valve control may involve one or more of the states as described below, and the one or more controllers may be configured accordingly. In particular, the valve control may comprise the fourth state followed by the sixth state and/or the seventh state. Optionally, the valve control may comprise any or all of the other states as well.

As Fig. 1 illustrates, in a first state the collection valve 140 may be maintained closed while the bypass valve 142 is open, for example when the reactor 110 is running to provide the deposition product. This allows transferring the deposition product, and any possible carrier gas, to the bypass exhaust. In this state, the deposition product may be directed 170 from the reactor to the bypass exhaust through the bypass valve. For the deposition product, path to the collection chamber may thus be blocked. In this state, the purge valve 144 and/or the exhaust valve 146 may also be closed. The first state may be considered as an initial state before collection of the deposition product into the collection chamber.

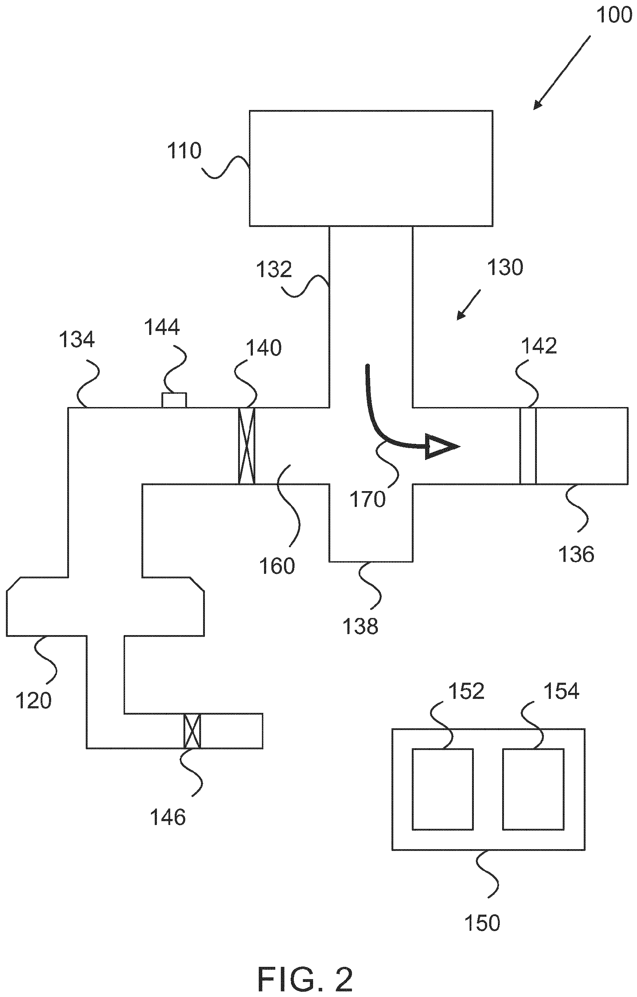

As Fig. 2 illustrates, in a second state an inlet valve may be open while the collection valve and the exhaust valve are closed for adjusting pressure difference across the collection valve. Gas, such as nitrogen, may be introduced through the inlet valve to adjust the pressure difference. As illustrated, the inlet valve may be the purge valve 144 but it may also be a different valve (not shown). The pressure difference may be larger on the side of the collection valve on which the inlet valve is situated. The opposite side of the collection valve, i.e. the side of the bypass valve may thus have lower pressure in comparison to the collection chamber and/or the space between the inlet valve and the collection valve. The bypass valve may be open.

The system may comprise one or more pressure gauges for facilitating the adjusting for the pressure difference. For this purpose, a (first) pressure gauge may be configured for measuring pressure downstream of the collection valve, for example in the collection arm, and/or a (second) pressure gauge may be configured for measuring pressure upstream of the collection valve, for example in the collection arm or the reactor arm. The one or more pressure gauges may be connected to the one or more controllers for facilitating the adjusting.

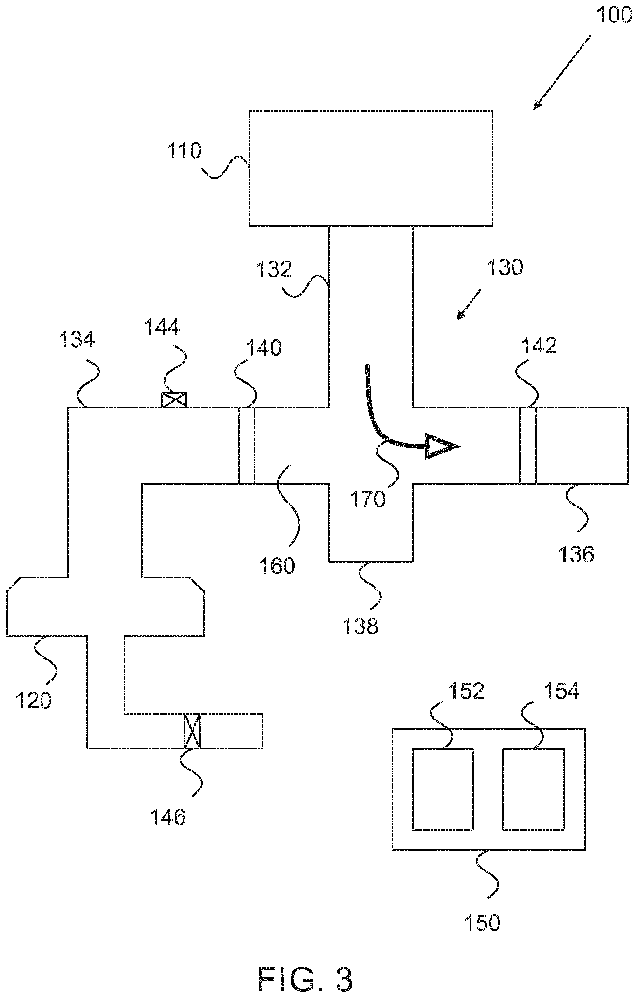

As Fig. 3 illustrates, in a third state the collection valve 140 may be open, while the exhaust valve is closed. When the bypass valve 142 is open, flow (e.g. of the deposition product) from the reactor may still be directed 170 fully or mainly towards the bypass valve, e.g. to the bypass exhaust. This is facilitated by the bypass exhaust providing a drain for the flow. If the pressure difference has been adjusted, for example as illustrated with reference to the second state, this may also direct the flow towards the bypass valve. The inlet valve and/or the purge valve 144 may be closed.

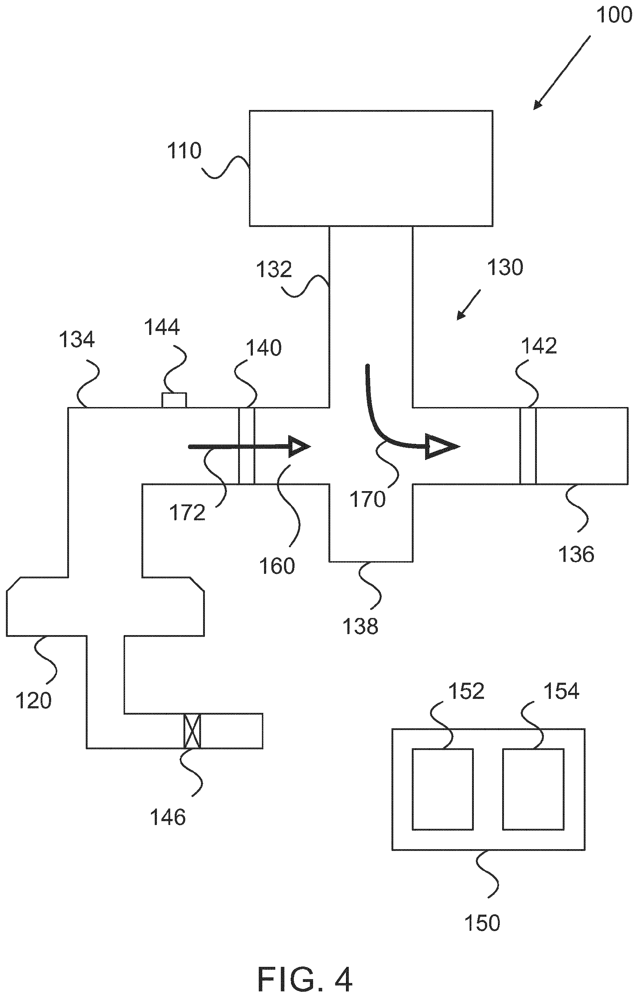

As Fig. 4 illustrates, in a fourth state a purging may be performed. For the purging, the collection valve 140, the bypass valve 142 and the purge valve 144 may all be open. This allows purging 172 debris 160 from between the collection valve and the bypass valve through the bypass valve. Gas from the purge valve, i.e. the purging gas, pushes the debris towards the bypass valve and it may then be transferred to the bypass exhaust. The system may also comprise one or more filters for removing the debris. The purging may be performed before the collection, i.e. before the deposition product is transferred into the collection chamber for treatment. This allows mitigation of the debris entering the collection chamber. The exhaust valve 146 may be closed. This allows mitigating flow towards the collection chamber. The treatment performed in the collection chamber may include deposition, such as chemical vapor deposition, or product collection, isolation, processing in a vacuum system, product removal and any combination thereof.

The flow (of the deposition product) directed 170 from the reactor to the bypass valve and the bypass exhaust may still take place at the same time. During the purging, the flow from the purge valve may be maintained smaller than the flow from the reactor.

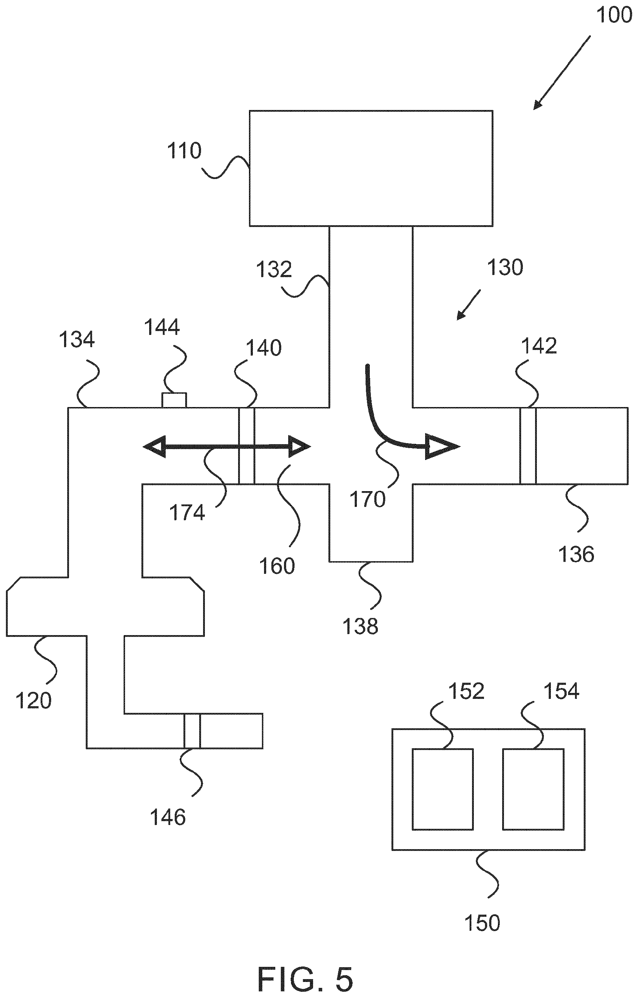

As Fig. 5 illustrates, in a fifth state the collection valve 140, the bypass valve 142 and the purge valve 144 may be open, while also the exhaust valve 146 is open. This may still provide the purging. However, it also allows flow 174 towards the collection chamber 120. While the purging could be performed in this state, this may also be used as a transition state from the purging to a collection state, where the treatment takes place.

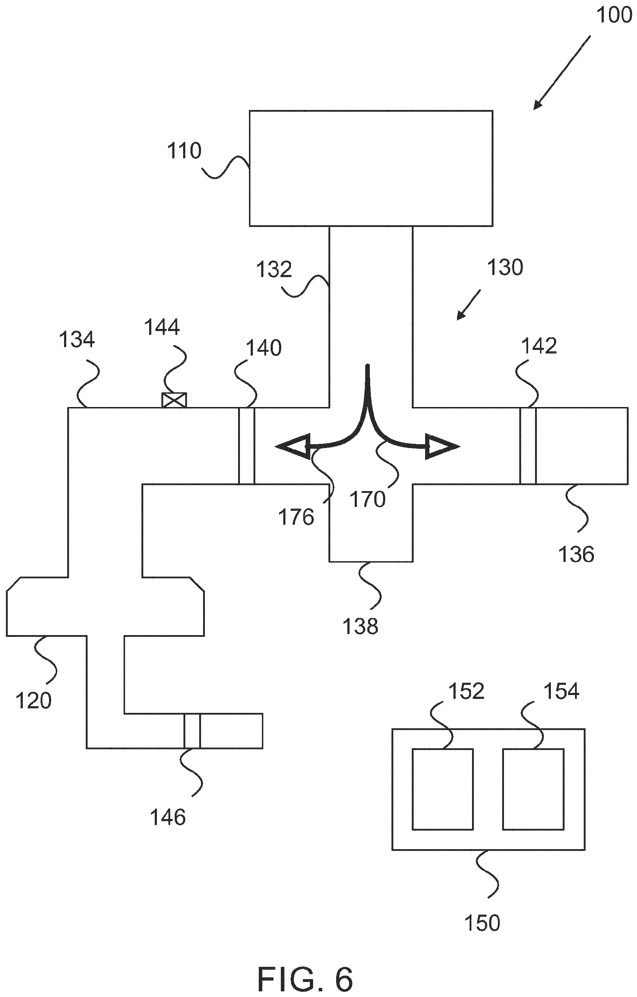

As Fig. 6 illustrates, in a sixth state the collection valve 140, the bypass valve 142 and the exhaust valve 146 may be open, allowing flow (of the deposition product) from the reactor 110 directed 170 towards the bypass valve/bypass exhaust but also directed 176 towards the collection chamber 120. The inlet valve and/or the purge valve 144 may be closed. While the collection may be performed in this state, this may also be used as a transition state from the purging to the collection state, for example after the fifth state.

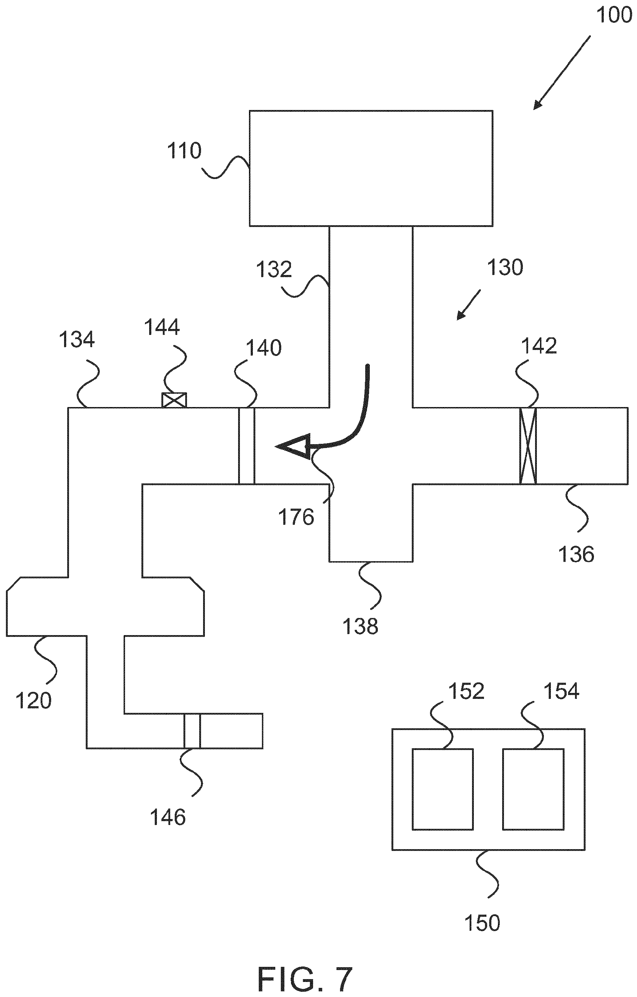

As Fig. 7 illustrates, in a seventh state the collection may be performed. This may be considered as the collection state. The collection valve 140 and the exhaust valve 146 may be open, allowing flow (of the deposition product) from the reactor 110 directed 176 towards the collection chamber 120. The inlet valve and/or the purge valve 144 may be closed. The bypass valve 142 may also be closed, allowing the flow of the deposition product to the bypass exhaust to be blocked. This can also markedly increase the flow from the reactor to the collection chamber.

As an example of the process, first the pressure difference between the volumes around the different sides of the collection valve may be adjusted. Then, the collection valve may be opened but the exhaust valve may be kept closed. Then, the inlet valve, which may be situated in the same arm downstream from the collection valve, may be opened so that gas is flown through the open collection valve to the direction opposite to the typical flow direction, i.e. in the upstream direction (towards the reactor and/or the bypass valve). Then, the exhaust valve is opened to let the gas flow to the collection chamber. Then, the inlet valve may be closed. Finally, the bypass valve, which can be seen as corresponding to the arm in which the gas was flowing prior to starting the sequence, is closed.

Successful operation of the system does not require the valves to be opened in the exact sequences indicated above. What is important is that the purging and the collection can be performed. For example, the one or more of the valves may be opened and/or closed simultaneously or in different order. As the valves may comprise one or more control valves, one or more of the valves may be continuously closed while one or more other valves are continuously closed. As an example, a transition from the fourth state to the sixth state or to the seventh state may be performed so that purge valve is closed simultaneously while the exhaust valve is opened and/or the bypass valve is closed. Accordingly, the exhaust valve may be opened simultaneously while the bypass valve and/or the purge valve is closed. During this process, the exhaust valve may be partially open while the bypass valve and/or the purge valve is partially open.

As another example, the purge valve may be closed after the purging and this may be done before or after the exhaust valve is opened. Alternatively or additionally, it may be done before or after the bypass valve is closed.

In general, it should be noted that directing the flow from the reactor and/or from the inlet valve may be performed by opening and/or closing the valves.

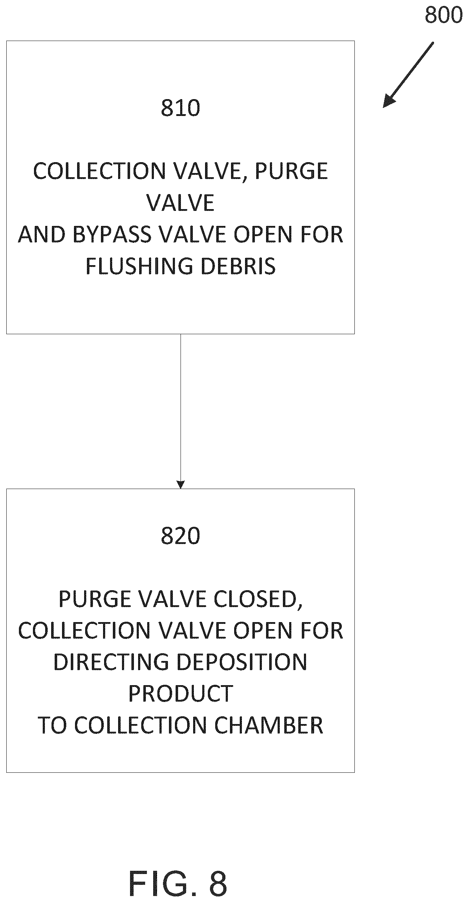

Figure 8 illustrates an example of a method 800. In the method, one or more of the steps may be performed at the same time or in different order. The method may be utilized for any of the systems as disclosed herein.

The method comprises having 810 the collection valve and the purge valve open while the bypass valve is open for purging debris from between the collection valve and the bypass valve through the bypass valve. Thereafter, the method comprises having 820 the purge valve closed and the collection valve open for directing the deposition product from the reactor to the collection chamber for treatment.

It should be understood that the number of collection chambers 120 may also be two or more. All examples disclosed herein should therefore be understood to apply also for the system comprising one or more additional collection chambers, which may be configured for chemical vapor deposition of the deposition product. Solutions disclosed herein for any single collection chamber (such as the collection arm, the collection valve, the purge valve and the exhaust valve, including their operation) may be replicated for any or all of the one or more additional collection chambers. Having multiple collection chambers allows selection for the place of the treatment. For any or all of these, the disclosed solutions for purging the debris, in particular at a collection valve controlling access to the corresponding collection chamber, may be used.

The different functions discussed herein may be performed in a different order and/or concurrently with each other.

Any range or device value given herein may be extended or altered without losing the effect sought, unless indicated otherwise. Any example may be combined with another example unless explicitly disallowed.

Although the subject matter has been de-scribed in language specific to structural features and/or acts, it is to be understood that the subject matter defined in the appended claims is not necessarily limited to the specific features or acts de-scribed above. Rather, the specific features and acts described above are disclosed as examples of implementing the claims and other equivalent features and acts are intended to be within the scope of the claims.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The term 'comprising' is used herein to mean including the method, blocks or elements identified, but that such blocks or elements do not comprise an exclusive list and a method or apparatus may contain additional blocks or elements.

Numerical descriptors such as 'first', 'second', and the like are used in this text simply as a way of differentiating between parts that otherwise have similar names. The numerical descriptors are not to be construed as indicating any particular order, such as an order of preference, manufacture, or occurrence in any particular structure.

Although the invention has been described in conjunction with a certain type of apparatus and/or method, it should be understood that the invention is not limited to any certain type of apparatus and/or method. While the present inventions have been described in connection with a number of examples, embodiments and implementations, the present inventions are not so limited, but rather cover various modifications, and equivalent arrangements, which fall within the purview of the claims. Although various examples have been described above with a certain degree of particularity, or with reference to one or more individual embodiments, those skilled in the art could make numerous alterations to the disclosed examples without departing from the scope of this specification.

## Claims

1. A method of valve control for a chemical vapor deposition (CVD) system having a reactor for creating a deposition product, a collection chamber for treatment of the deposition product and a gas distribution system (GDS) for transferring the deposition product from the reactor to the collection chamber, the method comprising:
- having a collection valve of the GDS between the reactor and the collection chamber and a purge valve of the GDS between a bypass valve and the collection chamber open while the bypass valve for the collection chamber is open for purging debris from between the purge valve and the bypass valve through the bypass valve, and thereafter,
- having the purge valve closed and the collection valve open for directing the deposition product from the reactor to the collection chamber for treatment.

2. The method of claim 1, wherein the purge valve is closed together with the bypass valve for directing the deposition product from the reactor to the collection chamber for the treatment.

3. The method of claim 1 or 2, wherein the collection valve is open together with an exhaust valve for the collection chamber for directing the deposition product from the reactor to the collection chamber for the treatment.

4. The method of claim 3, wherein the bypass valve and the exhaust valve are control valves, and the bypass valve is moved from an open position to a closed position as the exhaust valve is moved from a closed position to an open position for directing the deposition product from the reactor to the collection chamber for the treatment.

5. The method of claim 3 or 4, comprising having the collection valve and the exhaust valve closed while having an inlet valve open for adjusting pressure difference across the collection valve before opening the collection valve for purging the debris from between the collection valve and the bypass valve through the bypass valve.

6. The method of claim 5, wherein the inlet valve is the purge valve.

7. The method of any of the preceding claims, wherein a flow from the purge valve is maintained smaller during the purging in comparison to a flow from the reactor.

8. A chemical vapor deposition (CVD) system comprising:
- a reactor for creating a deposition product,
- a bypass valve for the collection chamber,
- a collection chamber for treatment of the deposition product,
- a gas distribution system (GDS) for transferring the deposition product from the reactor to the collection chamber, the GDS comprising:
∘ a collection valve between the reactor and the collection chamber,
∘ a purge valve between the collection valve and the collection chamber; and
∘ one or more controllers for controlling the bypass valve, the collection valve and the purge valve, the one or more controllers being configured to:
▪ have the collection valve and the purge valve open while the bypass valve is open for purging debris from between the collection valve and the bypass valve through the bypass valve, and thereafter,
▪ have the purge valve closed and the collection valve open for directing the deposition product from the reactor to the collection chamber for treatment.

9. System of claim 8, wherein the one or more controllers are configured to have the purge valve closed together with the bypass valve for directing the deposition product from the reactor to the collection chamber for the treatment.

10. System of claim 8 or 9 comprising an exhaust valve of the collection chamber, wherein the one or more controllers are configured to have the collection valve open together with the exhaust valve for directing the deposition product from the reactor to the collection chamber for the treatment.

11. System of claim 10, wherein the bypass valve and the exhaust valve are control valves, and the one or more controllers are configured to move the bypass valve from an open position to a closed position as the exhaust valve is moved from a closed position to an open position for directing the deposition product from the reactor to the collection chamber for the treatment.

12. The system of claim 10 or 11, wherein the one or more controllers are configured to have the collection valve and the exhaust valve closed while having an inlet valve open for adjusting pressure difference across the collection valve before opening the collection valve for purging the debris from between the collection valve and the bypass valve through the bypass valve.

13. The system of claim 12, wherein the inlet valve is the purge valve.

14. The system of any of claims 8-13, wherein the one or more controllers are configured to maintain a flow from the purge valve smaller during the purging in comparison to a flow from the reactor.
